# EUROPEAN PATENT APPLICATION

(11) **EP 4 769 898 A1**
(43) Date of publication of application: **01.07.2026**
(21) Application number: 25221801.1
(22) Date of filing: 09.12.2025
(51) Int. Cl.: H02J 9/06, H02J 3/38, H02J 3/388, G01R 31/42, G01R 31/55, G01R 31/67

(54) **BACKUP POWER SYSTEM AND POWER CABLE CONNECTION DETECTION METHOD THEREFOR**

(30) Priority: 30.12.2024 CN 202411985338
(71) Applicant: Huawei Technologies Co., Ltd., Shenzhen, Guangdong 518129 (CN)
(72) Inventor: ZHANG, Peng, Shenzhen, 518129 (CN); WEN, Jun, Shenzhen, 518129 (CN); SU, Bing, Shenzhen, 518129 (CN); ZHU, Dili, Shenzhen, 518129 (CN); WANG, Gang, Shenzhen, 518129 (CN)
(74) Representative: Isarpatent

(57) **Abstract**

This application provides a backup power system and a power cable connection detection method therefor. When an on/off-grid controller is powered by an inverter or a power grid, a switch circuit in the on/off-grid controller is disconnected, and cable connection detection is started. When a voltage is detected at only an inverter-side port or a grid-side port of the on/off-grid controller, a cable connection fault of the grid-side port is reported if it is determined that the following conditions are met: The voltage of the inverter-side port is greater than a first threshold, an output voltage of the inverter is less than the first threshold, and the inverter is shut down or in a startup process. When voltages are detected at both the inverter-side port and the grid-side port, a disturbance instruction is sent to the inverter, for the inverter to adjust the output voltage based on the disturbance instruction. If it is determined that the voltage of the grid-side port changes with the output voltage of the inverter, a cable connection fault of the inverter-side port is reported. In the foregoing detection manner, no manual intervention is required for checking cable connection in supplying power by a single power supply, and no additional detection component needs to be added. This reduces costs, and features simple logic, fast speed, and accurate detection.

## Description

### TECHNICAL FIELD

The present invention relates to the field of power electronics technologies, and in particular, to a backup power system and a power cable connection detection method therefor.

### BACKGROUND

A whole-house backup power system mainly includes an inverter and an on/off-grid controller, and may be powered in a plurality of manners such as a photovoltaic module, an energy storage apparatus, and a power grid, to implement stable power supply for a household load. The on/off-grid controller is connected between the inverter and the power grid. The household load may include a first load and a second load. A first power supply port that is in the on/off-grid controller and that is configured to connect to the first load is directly connected to an inverter-side port that is in the on/off-grid controller and that is configured to connect to an alternating current side of the inverter. The first load may be powered by the power grid or the inverter. A second power supply port that is in the on/off-grid controller and that is configured to connect to the second load is directly connected to a grid-side port that is in the on/off-grid controller and that is configured to connect to the power grid. The second load is powered by the power grid. The on/off-grid controller includes a control chip and a relay. The control chip mainly implements an on/off-grid switching function of the inverter by controlling on and off of the relay.

As a medium for connecting the inverter and the power grid, the on/off-grid controller is also an important carrier of a power cable. The inverter, various loads, and the power grid are all connected to the on/off-grid controller through the power cable. Because all ports inside the on/off-grid controller are alternating current cable connection ports, appearance, cable specifications, and colors of the ports are the same or similar. Although cable connection labels are provided on the on/off-grid controller, cables may still be connected to incorrect ports during mounting. For example, a cable led out from the inverter is connected to the grid-side port or the second power supply port of the on/off-grid controller, and the power grid is connected to the inverter-side port or the first power supply port of the on/off-grid controller. If there are power cables connected to incorrect ports, the backup power system cannot operate normally, and a device may be damaged or even personal safety may be affected.

### SUMMARY

This application provides a backup power system and a power cable connection detection method therefor, to detect a problem of incorrect connection of power cables in the backup power system.

According to a first aspect, this application provides a backup power system, including an inverter and an on/off-grid controller. The on/off-grid controller includes an inverter-side port and a grid-side port. The inverter-side port is configured to connect to an alternating current side of the inverter, and the grid-side port is configured to connect to a power grid. The on/off-grid controller includes a switch circuit and a control circuit, and the switch circuit is connected between the grid-side port and the inverter-side port. The control circuit is configured to: disconnect the switch circuit and start cable connection detection.

When the control circuit of the on/off-grid controller detects that only the inverter-side port or the grid-side port has a voltage, that is, when the voltage of the grid-side port is less than a first threshold, the control circuit of the on/off-grid controller may determine, based on the voltage of the inverter-side port, an output voltage of the inverter, and an operating status of the inverter, whether a cable connection abnormality exists. Specifically, when the control circuit of the on/off-grid controller determines that the following conditions are met: The voltage of the inverter-side port is greater than the first threshold, the output voltage of the inverter is less than the first threshold, and the inverter is shut down or in a startup process, that is, the inverter-side port has a voltage, the inverter has no output voltage, and the inverter is in the non-operating state (including a shutdown or startup process), it indicates that a cable of the power grid is connected to the inverter-side port or the first power supply port of the on/off-grid controller, and a cable connection fault of the grid-side port needs to be reported. On the contrary, if the control circuit determines that any one of the foregoing conditions is not met, it is considered that system cable connection is normal. In this case, detection ends, and the backup power system operates normally.

When the control circuit of the on/off-grid controller detects that both the inverter-side port and the grid-side port have voltages, that is, when the voltage of the inverter-side port is greater than the first threshold and the voltage of the grid-side port is greater than the first threshold, the control circuit of the on/off-grid controller sends a disturbance instruction to the inverter, for the inverter to adjust the output voltage based on the disturbance instruction. When the control circuit determines that the voltage of the grid-side port changes with the output voltage of the inverter, it indicates that an output cable of the inverter is connected to the grid-side port or the second power supply port, and a cable connection fault of the inverter-side port needs to be reported. On the contrary, if the control circuit determines that the voltage of the grid-side port does not change with the output voltage of the inverter, it is considered that system cable connection is normal. In this case, detection ends, and the backup power system operates normally.

In the foregoing detection manner, whether cable connection is abnormal may be automatically detected in an operation process of the backup power system, and no manual intervention is required for checking cable connection in supplying power by a single power supply. In addition, detection can be completed based on a voltage control unit and a sampling unit in the backup power system, and no additional detection component needs to be added. This reduces costs, and features simple logic, fast speed, and accurate detection.

In some embodiments of this application, after receiving the disturbance instruction, the inverter disturbs the output voltage of the inverter in a small amplitude range. Specifically, the following manner may be used for implementation: The inverter first controls, based on the disturbance instruction, the output voltage to be a first amplitude for first duration, where the first amplitude may be greater than a rated voltage amplitude of the power grid; and then, the inverter controls the output voltage to be a second amplitude for second duration, where the second amplitude may be less than the rated voltage amplitude of the power grid. The first duration and the second duration may have a same value, or may have different values. In addition, the inverter may further control the output voltage for repeatedly performing more than one group of operations. Correspondingly, the control circuit determines that the voltage of the grid-side port changes with the output voltage of the inverter. Specifically, the following manner may be used for implementation: determining that the voltage of the grid-side port is a third amplitude for third duration and then the voltage of the grid-side port is a fourth amplitude for fourth duration, and reporting the cable connection fault of the inverter-side port. The third amplitude is greater than the rated voltage amplitude of the power grid and less than the first amplitude, and the fourth amplitude is less than the rated voltage amplitude of the power grid and greater than the second amplitude. The third duration is less than the first duration, and the fourth duration is less than the second duration.

In some other embodiments of this application, after receiving the disturbance instruction, the inverter disturbs the output voltage of the inverter in a small amplitude range. Specifically, the following manner may be used for implementation: The inverter first controls, based on the disturbance instruction, the output voltage to be a second amplitude for first duration, and then the inverter controls the output voltage to be a first amplitude for second duration. Correspondingly, the control circuit determines that the voltage of the grid-side port changes with the output voltage of the inverter. Specifically, the following manner may be used for implementation: determining that the voltage of the grid-side port is a fourth amplitude for third duration and then the voltage of the grid-side port is a third amplitude for fourth duration, and reporting the cable connection fault of the inverter-side port.

For example, the first amplitude is (1+k2)Un, where k2 is a coefficient, and a value of k2 is between 0 and 1. For example, the value of k2 may be 0.05. The first duration t1 may be 3 seconds. The second amplitude is (1-k3)Un, where k3 is a coefficient, and a value of k3 is between 0 and 1. For example, the value of k3 may be 0.05. The second duration t2 may be 3 seconds. The first duration and the second duration may have a same value, or may have different values. The third amplitude is (1+k4)Un, where k4 is a coefficient, and a value of k4 is between 0 and 1. k4 is slightly less than k2. For example, the value of k4 may be 0.03. The fourth amplitude is (1-k5)Un, where k5 is a coefficient, and a value of k5 is between 0 and 1. k5 is slightly less than k3. For example, the value of k5 may be 0.03. The third duration is less than the first duration, and the fourth duration is less than the second duration.

In some embodiments of this application, the control circuit is further configured to: after reporting the cable connection fault, control the on/off-grid controller to be shut down, and send a shutdown instruction to the inverter.

In some embodiments of this application, the system further includes a system controller. The system controller is configured to: forward, to the inverter, the disturbance instruction sent by the control circuit, and forward, to the control circuit, the output voltage and an operating status that are sent by the inverter, where the operating status includes on-grid operation, off-grid operation, shutdown, and startup.

In some embodiments of this application, the on/off-grid controller further includes a first power supply port and a second power supply port. The first power supply port is configured to connect to a first load, and the second power supply port is configured to connect to a second load. The first power supply port is connected to the inverter-side port, and the second power supply port is connected to the grid-side port.

In some embodiments of this application, the switch circuit includes a first relay and a second relay that are connected in series. The first relay is connected to the inverter-side port, and the second relay is connected to the grid-side port.

According to a second aspect, this application provides a power cable connection detection method for a backup power system, including the following steps: disconnecting a switch circuit that is in an on/off-grid controller and that is connected between a grid-side port and an inverter-side port, where the inverter-side port is configured to connect to an alternating current side of an inverter, and the grid-side port is configured to connect to a power grid; when a voltage of the inverter-side port is greater than a first threshold and a voltage of the grid-side port is greater than the first threshold, sending a disturbance instruction to the inverter, for the inverter to adjust an output voltage based on the disturbance instruction, and if the voltage of the grid-side port changes with the output voltage of the inverter, reporting a cable connection fault of the inverter-side port; and when the voltage of the grid-side port is less than the first threshold, if the voltage of the inverter-side port is greater than the first threshold, the output voltage of the inverter is less than the first threshold, and the inverter is shut down or in a startup process, reporting a cable connection fault of the grid-side port.

In some embodiments of this application, that the inverter adjusts the output voltage based on the disturbance instruction may specifically include: controlling, based on the disturbance instruction, the output voltage to be a first amplitude for first duration and then controlling the output voltage to be a second amplitude for second duration, where the first amplitude is greater than a rated voltage amplitude of the power grid, and the second amplitude is less than the rated voltage amplitude of the power grid. A case in which the voltage of the grid-side port changes with the output voltage of the inverter may specifically include: if the voltage of the grid-side port is a third amplitude for third duration, and then the voltage of the grid-side port is a fourth amplitude for fourth duration, reporting the cable connection fault of the inverter-side port, where the third amplitude is greater than the rated voltage amplitude of the power grid and less than the first amplitude, the fourth amplitude is less than the rated voltage amplitude of the power grid and greater than the second amplitude, the third duration is less than the first duration, and the fourth duration is less than the second duration.

In some other embodiments of this application, that the inverter adjusts the output voltage based on the disturbance instruction may specifically include: controlling, based on the disturbance instruction, the output voltage to be a second amplitude for first duration, and controlling the output voltage to be a first amplitude for second duration, where the first amplitude is greater than a rated voltage amplitude of the power grid, and the second amplitude is less than the rated voltage amplitude of the power grid. A case in which the voltage of the grid-side port changes with the output voltage of the inverter may specifically include: if the voltage of the grid-side port is a fourth amplitude for third duration, and then the voltage of the grid-side port is a third amplitude for fourth duration, reporting the cable connection fault of the inverter-side port, where the third amplitude is greater than the rated voltage amplitude of the power grid and less than the first amplitude, the fourth amplitude is less than the rated voltage amplitude of the power grid and greater than the second amplitude, the third duration is less than the first duration, and the fourth duration is less than the second duration.

For example, the first amplitude is (1+k2)Un, where k2 is a coefficient, and a value of k2 is between 0 and 1. For example, the value of k2 may be 0.05. The first duration t1 may be 3 seconds. The second amplitude is (1-k3)Un, where k3 is a coefficient, and a value of k3 is between 0 and 1. For example, the value of k3 may be 0.05. The second duration t2 may be 3 seconds. The first duration and the second duration may have a same value, or may have different values. The third amplitude is (1+k4)Un, where k4 is a coefficient, and a value of k4 is between 0 and 1. k4 is slightly less than k2. For example, the value of k4 may be 0.03. The fourth amplitude is (1-k5)Un, where k5 is a coefficient, and a value of k5 is between 0 and 1. k5 is slightly less than k3. For example, the value of k5 may be 0.03. The third duration is less than the first duration, and the fourth duration is less than the second duration.

In some embodiments of this application, after the cable connection fault is reported, the on/off-grid controller and the inverter may be further controlled to be shut down.

### BRIEF DESCRIPTION OF DRAWINGS

FIG. 1 is a diagram of a structure of a backup power system;
FIG. 2 is a diagram of a structure of a backup power system according to an embodiment of this application;
FIG. 3 is a diagram of a circuit structure of a single-phase on/off-grid controller according to an embodiment of this application; and
FIG. 4A and FIG. 4B are a schematic flowchart of a power cable connection detection method for the backup power system according to an embodiment of this application.

### DESCRIPTION OF EMBODIMENTS

To make the objectives, technical solutions, and advantages of this application clearer, the following further describes this application in detail with reference to the accompanying drawings. However, example embodiments may be implemented in a plurality of forms and should not be construed as being limited to embodiments described herein. On the contrary, these embodiments are provided such that this application is more comprehensive and complete and fully conveys the concept of the example embodiments to persons skilled in the art. Identical reference numerals in the accompanying drawings denote identical or similar structures. Therefore, repeated description thereof is omitted. Terms that are described in this application and that express a position and a direction are all described by using the accompanying drawings as examples, but changes may also be made as required, and all the changes fall within the protection scope of this application. The accompanying drawings in this application are merely used to illustrate relative position relationships and do not represent an actual scale.

It should be noted that specific details are set forth in the following descriptions for ease of fully understanding this application. However, this application can be implemented in a plurality of manners different from those described herein, and a person skilled in the art can perform similar promotion without departing from the connotation of this application. Therefore, this application is not limited to the following disclosed specific implementations. The following descriptions of this specification are example manners of implementing this application. However, the descriptions are intended to describe the general principle of this application, and are not intended to limit the scope of this application. The protection scope of this application shall be defined by the appended claims.

To facilitate understanding of embodiments of this application, the following first describes related technologies in embodiments of this application.

Terms used in the following embodiments are merely intended to describe specific embodiments, but are not intended to limit this application. Terms "one", "a", and "this" of singular forms used in this specification and the appended claims of this application are also intended to include a form like "one or more", unless otherwise specified in the context clearly. It may be further understood that, in the following embodiments of this application, "at least one" means one, two, or more.

Reference to "an embodiment" or the like described in this specification means that one or more embodiments of this application include a particular feature, structure, or characteristic described in combination with the embodiment. Therefore, statements such as "in an embodiment", "in some embodiments", and "in other embodiments" that appear at different places in this specification do not necessarily mean referring to a same embodiment. Instead, the statements mean referring to "one or more but not all of embodiments", unless otherwise specifically emphasized in another manner. The terms "include", "have", and variants of the terms all mean "include but are not limited to", unless otherwise specifically emphasized in another manner.

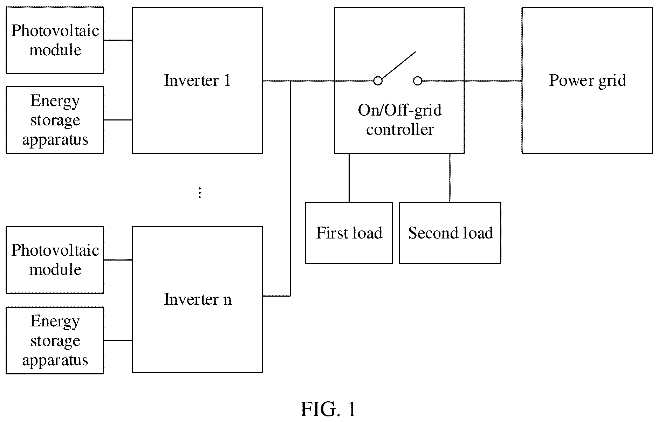

Refer to FIG. 1. A backup power system mainly includes an inverter and an on/off-grid controller. The on/off-grid controller is connected between the inverter and a power grid. The inverter is configured to convert a direct current provided by a photovoltaic module or an energy storage apparatus into an alternating current. The on/off-grid controller includes a first power supply port, a second power supply port, an inverter-side port, and a grid-side port. The first power supply port is directly connected to the inverter-side port, the second power supply port is directly connected to the grid-side port, the inverter-side port is connected to an alternating current side of the inverter, and the grid-side port is configured to connect to the power grid. A plurality of inverters may be disposed in the backup power system. Correspondingly, the on/off-grid controller may be disposed with an inverter-side port connected to an alternating current side of each inverter in a one-to-one correspondence manner. Household loads connected to the on/off-grid controller include a first load and a second load. The first power supply port is configured to connect to the first load, and the second power supply port is configured to connect to the second load. The first load may be powered by the power grid or the inverter, and the second load is powered by the power grid.

The on/off-grid controller internally includes a control chip and a relay. The control chip mainly implements an on/off-grid switching function of the inverter by controlling on and off of the relay. When the power grid is normal, the control chip controls the relay to be turned on, and the backup power system operates in an on-grid manner to supply power to the first load. When the power grid is powered off, the control chip controls the relay to be turned off, and the inverter operates in an off-grid manner to supply power to the first load, to ensure that the first load can always operate normally.

Because all ports inside the on/off-grid controller are alternating current cable connection ports, appearance, cable specifications, and colors of the ports are the same or similar. Although cable connection labels are provided on the on/off-grid controller, cables may still be connected to incorrect ports during mounting. For example, a cable led out from the inverter is connected to the grid-side port or the second power supply port of the on/off-grid controller, and the power grid is connected to the inverter-side port or the first power supply port of the on/off-grid controller. If there are power cables connected to incorrect ports, the backup power system cannot operate normally, and a device may be damaged, or even personal safety may be affected.

Currently, for incorrect connection of power cables in the backup power system, technical solutions of cable connection detection are as follows: (1) Each cable connection is detected one by one by supplying power by a single power supply, and whether cable connection is normal is determined based on a voltage sampling result after power supply. For example, the inverter is controlled to stop operating, and all relays in the on/off-grid controller are in an off state. The backup power system is powered by only the power grid, and voltages of the ports inside the on/off-grid controller are collected, and are compared with a preset voltage to determine whether cable connection is normal. One by one detection of each cable connection by supplying power by a single power supply requires manual intervention, takes a long time, and is inefficient. (2) An actual cable connection image is captured by an image capture device, and is compared with a standard cable connection image to determine whether a power cable is incorrectly connected. The image comparison method is applicable to only a scenario in which cable connection ports are inconsistent. When sizes and colors of cable connection ports and cables inside the device are consistent, incorrect connection cannot be correctly identified.

In view of this, to resolve a problem that detection time is long and detection efficiency is low because manual intervention is required for ensuring detection of a cable connection status of a cable in supplying power by a single power supply, and a problem that when cable connection ports are consistent, incorrect connection cannot be correctly identified by comparing images, embodiments of this application provide a backup power system and a power cable connection detection method therefor, to quickly detect a problem of incorrect connection of a power cable in the backup power system.

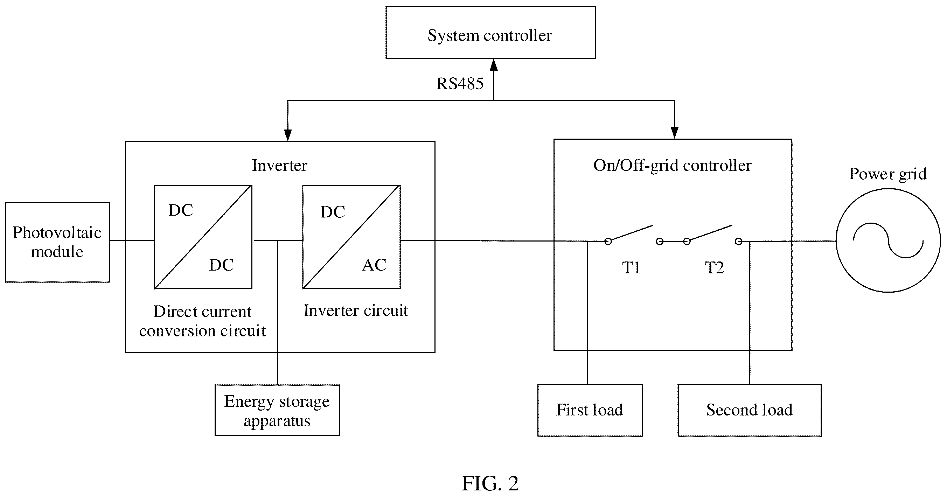

Refer to FIG. 2. The backup power system provided in embodiments of this application includes an inverter and an on/off-grid controller. The backup power system may further include a system controller mainly configured to implement functions such as system communication transmission, power scheduling, and information reporting. Generally, the system controller is connected to the inverter and the on/off-grid controller through one RS485 communication cable. The inverter is connected between a direct current source and the on/off-grid controller. A direct current side of the inverter is configured to connect to the direct current source. The direct current source may be specifically a photovoltaic module. The direct current source may alternatively be an energy storage apparatus. An alternating current side of the inverter is connected to an inverter side of the on/off-grid controller. The inverter is configured to convert a direct current provided by the photovoltaic module or the energy storage apparatus into an alternating current. The inverter may specifically include an inverter circuit, and may further include a direct current conversion circuit. The direct current conversion circuit is configured to perform power conversion on the direct current provided by the photovoltaic module. The inverter circuit is configured to convert a direct current provided by the direct current conversion circuit or the direct current provided by the energy storage apparatus into an alternating current. The on/off-grid controller may specifically include a switch circuit and a control circuit (not shown in FIG. 2). A grid side of the switch circuit is configured to connect to a power grid, and an inverter side of the switch circuit is connected to the alternating current side of the inverter. To meet a power consumption safety requirement, the switch circuit generally includes two levels of switches, namely, a first relay T1 and a second relay T2 that are connected in series.

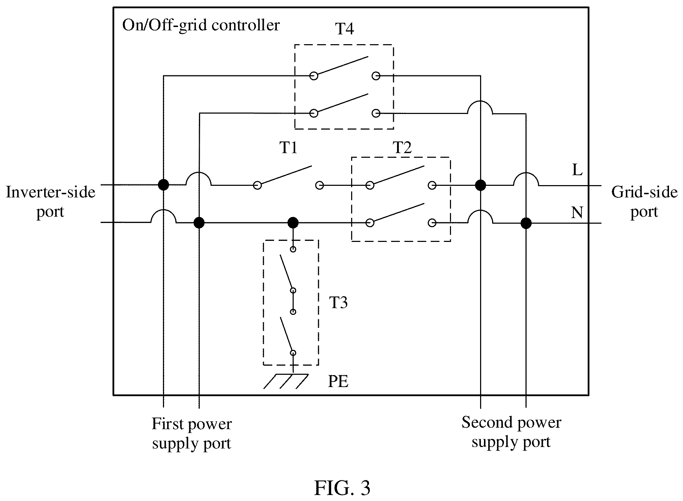

Refer to FIG. 3. The on/off-grid controller includes two ports, which are specifically an inverter-side port and a grid-side port. The inverter-side port is configured to connect to the alternating current side of the inverter, and the grid-side port is configured to connect to the power grid. The switch circuit is connected between the grid-side port and the inverter-side port. Specifically, the first relay T1 is connected to the inverter-side port, and the second relay T2 is connected to the grid-side port. Optionally, the on/off-grid controller may further include a first power supply port and a second power supply port. The first power supply port is connected to the inverter-side port, the second power supply port is connected to the grid-side port, the first power supply port is configured to connect to a first load, and the second power supply port is configured to connect to a second load. A plurality of inverters may be disposed in the backup power system. Correspondingly, the on/off-grid controller may be disposed with an inverter-side port configured to connect to an alternating current side of each inverter in a one-to-one correspondence manner. Refer to FIG. 3. The on/off-grid controller provided in this application may be a single-phase on/off-grid controller. In addition, the on/off-grid controller may further include an NPE relay T3 connected between a neutral wire N and a ground wire PE, and a bypass switch T4 connected between the inverter-side port and the grid-side port.

In this application, when the on/off-grid controller is powered by the inverter or the power grid, and the backup power system needs to perform cable connection detection, a control circuit of the on/off-grid controller first disconnects the switch circuit in the on/off-grid controller, to disconnect the inverter-side port from the grid-side port inside the on/off-grid controller. In this way, a voltage of the inverter-side port changes based on a voltage of a connected cable, a voltage of the grid-side port changes based on a voltage of a connected cable, and cable connection detection is started, to detect the voltage of the inverter-side port and the voltage of the grid-side port and perform corresponding logical determining.

When the control circuit of the on/off-grid controller detects that only the inverter-side port or the grid-side port has a voltage, that is, when the voltage of the grid-side port is less than a first threshold, the control circuit of the on/off-grid controller may determine, based on the voltage of the inverter-side port, an output voltage of the inverter, and an operating status of the inverter, whether a cable connection abnormality exists. The voltage of the inverter-side port may be obtained by the on/off-grid controller through sampling. The output voltage of the inverter and the operating status of the inverter are transmitted to the on/off-grid controller by the inverter through an RS485 communication cable and a system controller after sampling. The operating status of the inverter includes off-grid operation, on-grid operation, shutdown, or startup. The inverter is in a non-operating state, that is, in a startup process or is shut down. When the control circuit of the on/off-grid controller determines that the following conditions are met: The voltage of the inverter-side port is greater than the first threshold, the output voltage of the inverter is less than the first threshold, and the inverter is shut down or in a startup process, that is, the inverter-side port has a voltage, the inverter has no output voltage, and the inverter is in the non-operating state, it indicates that a cable of the power grid is connected to the inverter-side port or the first power supply port of the on/off-grid controller, and a cable connection fault of the grid-side port needs to be reported. Further, the control circuit may further control the on/off-grid controller to be shut down, and send a shutdown instruction to the inverter through the RS485 communication cable and the system controller, so that the inverter is shut down. On the contrary, if the control circuit determines that any one of the foregoing conditions is not met, it is considered that system cable connection is normal. In this case, detection ends, and the backup power system operates normally.

When the control circuit of the on/off-grid controller detects that both the inverter-side port and the grid-side port have voltages, that is, when the voltage of the inverter-side port is greater than the first threshold and the voltage of the grid-side port is greater than the first threshold, the control circuit of the on/off-grid controller sends a disturbance instruction to the inverter, for the inverter to adjust the output voltage based on the disturbance instruction. For example, the control circuit may transmit the disturbance instruction to the on/off-grid controller through the RS485 communication cable and the system controller. After receiving the disturbance instruction, the inverter disturbs the output voltage of the inverter in a small amplitude range. When the control circuit determines that the voltage of the grid-side port changes with the output voltage of the inverter, it indicates that an output cable of the inverter is connected to the grid-side port or the second power supply port, and a cable connection fault of the inverter-side port needs to be reported. Further, the control circuit may further control the on/off-grid controller to be shut down, and send a shutdown instruction to the inverter through the RS485 communication cable and the system controller, so that the inverter is shut down. On the contrary, if the control circuit determines that the voltage of the grid-side port does not change with the output voltage of the inverter, it is considered that system cable connection is normal. In this case, detection ends, and the backup power system operates normally.

In the foregoing detection manner, whether cable connection is abnormal may be automatically detected in an operation process of the backup power system, and no manual intervention is required for checking cable connection in supplying power by a single power supply. In addition, detection can be completed based on a voltage control unit and a sampling unit in the backup power system, and no additional detection component needs to be added. This reduces costs, and features simple logic, fast speed, and accurate detection.

In some embodiments of this application, after receiving the disturbance instruction, the inverter disturbs the output voltage of the inverter in a small amplitude range. Specifically, the following manner may be used for implementation: The inverter first controls, based on the disturbance instruction, the output voltage to be a first amplitude for first duration. The first amplitude may be greater than a rated voltage amplitude Un of the power grid. For example, the first amplitude is (1+k2)Un, where k2 is a coefficient, for example, may be 0.05. The first duration t1 may be 3 seconds. Then, the inverter controls the output voltage to be a second amplitude for second duration. The second amplitude may be less than the rated voltage amplitude of the power grid. For example, the second amplitude is (1-k3)Un, where k3 is a coefficient, for example, may be 0.05. The second duration t2 may be 3 seconds. The first duration t1 and the second duration t2 may have a same value, or may have different values. In addition, the inverter may further control the output voltage for repeatedly performing more than one group of operations.

Correspondingly, the control circuit determines that the voltage of the grid-side port changes with the output voltage of the inverter. Specifically, the following manner may be used for implementation: determining that the voltage of the grid-side port is a third amplitude for third duration and then the voltage of the grid-side port is a fourth amplitude for fourth duration, and reporting the cable connection fault of the inverter-side port. The third amplitude is greater than the rated voltage amplitude of the power grid and less than the first amplitude. For example, the third amplitude is (1+k4)Un, where k4 is a coefficient slightly less than k2, for example, may be 0.03. The fourth amplitude is less than the rated voltage amplitude of the power grid and greater than the second amplitude. For example, the fourth amplitude is (1-k5)Un, where k5 is a coefficient slightly less than k3, for example, may be 0.03. The third duration t3 is less than the first duration t1, for example, may be 2 seconds, and the fourth duration t4 is less than the second duration t2, for example, may be 2 seconds.

Alternatively, in some other embodiments of this application, after receiving the disturbance instruction, the inverter disturbs the output voltage of the inverter in a small amplitude range. Specifically, the following manner may be used for implementation: The inverter first controls, based on the disturbance instruction, the output voltage to be a second amplitude for first duration, and then the inverter controls the output voltage to be a first amplitude for second duration.

Correspondingly, the control circuit determines that the voltage of the grid-side port changes with the output voltage of the inverter. Specifically, the following manner may be used for implementation: determining that the voltage of the grid-side port is a fourth amplitude for third duration and then the voltage of the grid-side port is a third amplitude for fourth duration, and reporting the cable connection fault of the inverter-side port.

Based on a same inventive concept, an embodiment of this application further provides a power cable connection detection method, including the following steps:
disconnecting a switch circuit that is in an on/off-grid controller and that is connected between a grid-side port and an inverter-side port, where the inverter-side port is configured to connect to an alternating current side of an inverter, and the grid-side port is configured to connect to a power grid;
when a voltage of the inverter-side port is greater than a first threshold and a voltage of the grid-side port is greater than the first threshold, sending a disturbance instruction to the inverter, for the inverter to adjust an output voltage based on the disturbance instruction, and if the voltage of the grid-side port changes with the output voltage of the inverter, reporting a cable connection fault of the inverter-side port; and
when the voltage of the grid-side port is less than the first threshold, if the voltage of the inverter-side port is greater than the first threshold, the output voltage of the inverter is less than the first threshold, and the inverter is shut down or in a startup process, reporting a cable connection fault of the grid-side port.

In some embodiments of this application, that the inverter adjusts the output voltage based on the disturbance instruction may specifically include: controlling, based on the disturbance instruction, the output voltage to be a first amplitude for first duration and then controlling the output voltage to be a second amplitude for second duration, where the first amplitude is greater than a rated voltage amplitude of the power grid, and the second amplitude is less than the rated voltage amplitude of the power grid.

A case in which the voltage of the grid-side port changes with the output voltage of the inverter may specifically include: if the voltage of the grid-side port is a third amplitude for third duration, and the voltage of the grid-side port is a fourth amplitude for fourth duration, reporting the cable connection fault of the inverter-side port, where the third amplitude is greater than the rated voltage amplitude of the power grid and less than the first amplitude, the fourth amplitude is less than the rated voltage amplitude of the power grid and greater than the second amplitude, the third duration is less than the first duration, and the fourth duration is less than the second duration.

Alternatively, in some other embodiments of this application, that the inverter adjusts the output voltage based on the disturbance instruction may specifically include: controlling, based on the disturbance instruction, the output voltage to be a second amplitude for first duration, and controlling the output voltage to be a first amplitude for second duration, where the first amplitude is greater than a rated voltage amplitude of the power grid, and the second amplitude is less than the rated voltage amplitude of the power grid; and

A case in which the voltage of the grid-side port changes with the output voltage of the inverter may specifically include: if the voltage of the grid-side port is a fourth amplitude for third duration, and the voltage of the grid-side port is a third amplitude for fourth duration, reporting the cable connection fault of the inverter-side port, where the third amplitude is greater than the rated voltage amplitude of the power grid and less than the first amplitude, the fourth amplitude is less than the rated voltage amplitude of the power grid and greater than the second amplitude, the third duration is less than the first duration, and the fourth duration is less than the second duration.

In some embodiments of this application, after the cable connection fault is reported, the on/off-grid controller and the inverter may be further controlled to be shut down.

The following describes in detail a cable connection detection manner provided in this application by using specific embodiments.

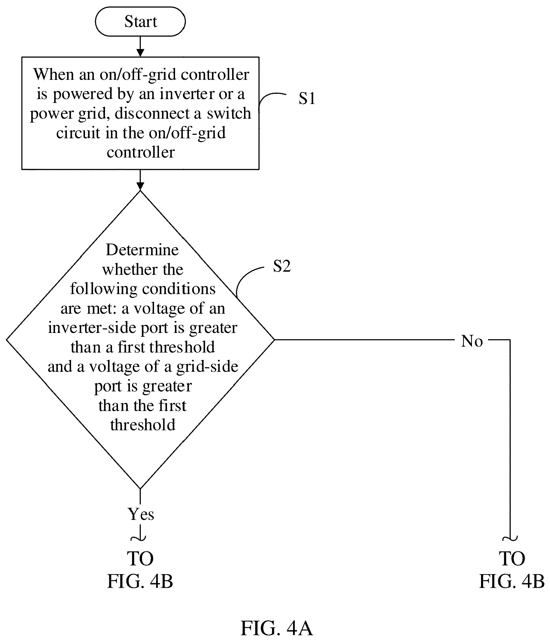

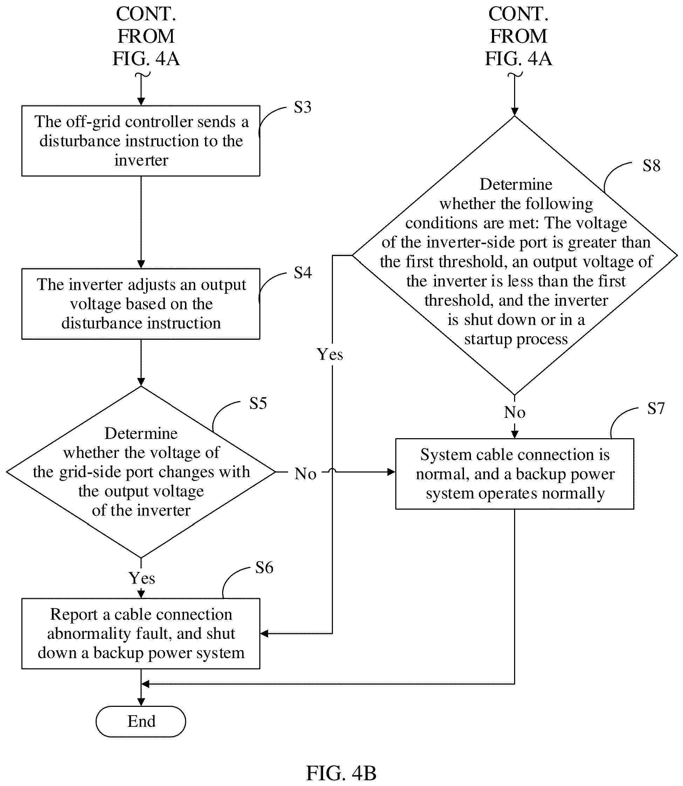

Refer to FIG. 4A and FIG. 4B. A power cable connection detection method proposed in this application for a problem of incorrect power cable connection in a backup power system includes the following steps.

S1: When an on/off-grid controller is powered by an inverter or a power grid, and the backup power system needs to perform cable connection detection, a control circuit of the on/off-grid controller disconnects a switch circuit in the on/off-grid controller, and starts cable connection detection.

S2: Determine whether a voltage of an inverter-side port is greater than a first threshold and whether a voltage of a grid-side port is greater than the first threshold. Specifically, the first threshold may be k1Un, where Un is a rated voltage amplitude of the power grid, and k1 is a coefficient, for example, may be 0.5.

S3: When it is determined that the voltage of the inverter-side port is greater than the first threshold and the voltage of the grid-side port is greater than the first threshold, the on/off-grid controller sends a disturbance instruction to the inverter.

S4: The inverter adjusts an output voltage based on the disturbance instruction. A start moment for sending the disturbance instruction is set to t0. After receiving the disturbance instruction, the inverter starts to disturb the output voltage in a small amplitude range. For example, the inverter first controls the output voltage to be a first amplitude for first duration. The first amplitude may be greater than the rated voltage amplitude of the power grid. For example, the first amplitude is (1+k2)Un, where k2 is a coefficient, for example, may be 0.05. The first duration t1 may be 3 seconds. Then, the inverter controls the output voltage to be a second amplitude for second duration. The second amplitude may be less than the rated voltage amplitude of the power grid. For example, the second amplitude is (1-k3)Un, where k3 is a coefficient, for example, may be 0.05. The second duration t2 may be 3 seconds. The first duration t1 and the second duration t2 may have a same value, or may have different values. In addition, the inverter may further control the output voltage for repeatedly performing more than one group of operations.

S5: The on/off-grid controller determines whether the voltage of the grid-side port changes with the output voltage of the inverter. For example, in a time window [t0, tx], it is determined whether the voltage of the grid-side port is a third amplitude for third duration, and then the voltage of the grid-side port is a fourth amplitude for fourth duration. The third amplitude is greater than the rated voltage amplitude of the power grid and less than the first amplitude. For example, the third amplitude is (1+k4)Un, where k4 is a coefficient slightly less than k2, for example, may be 0.03. The fourth amplitude is less than the rated voltage amplitude of the power grid and greater than the second amplitude. For example, the fourth amplitude is (1-k5)Un, where k5 is a coefficient slightly less than k3, for example, may be 0.03. The third duration t3 is less than the first duration t1, for example, may be 2 seconds. The fourth duration t4 is less than the second duration t2, for example, may be 2 seconds. A value of tx is generally 8 seconds to 12 seconds.

S6: When the control circuit determines that the voltage of the grid-side port changes with the output voltage of the inverter, it indicates that an output cable of the inverter is connected to the grid-side port or a second power supply port, a cable connection fault of the inverter-side port is reported, and the backup power system is shut down.

S7: When the control circuit determines that the voltage of the grid-side port does not change with the output voltage of the inverter, it is considered that cable connection of the backup power system is normal. In this case, detection ends, and the backup power system operates normally.

S8: When the voltage of the grid-side port is less than the first threshold, the control circuit of the on/off-grid controller determines whether the following conditions are met: The voltage of the inverter-side port is greater than the first threshold, the output voltage of the inverter is less than the first threshold, and the inverter is shut down or in a startup process.

If all the conditions are met, it indicates that a cable of the power grid is connected to the inverter-side port or a first power supply port of the on/off-grid controller, and a cable connection fault of the grid-side port needs to be reported. On the contrary, if the control circuit determines that any one of the foregoing conditions is not met, it is considered that system cable connection is normal. In this case, detection ends, and the backup power system operates normally.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A backup power system, comprising an inverter and an on/off-grid controller, wherein the on/off-grid controller comprises an inverter-side port and a grid-side port, the inverter-side port is configured to connect to an alternating current side of the inverter, and the grid-side port is configured to connect to a power grid;
the on/off-grid controller comprises a switch circuit and a control circuit, and the switch circuit is connected between the grid-side port and the inverter-side port; and
the control circuit is configured to: disconnect the switch circuit;
when a voltage of the inverter-side port is greater than a first threshold and a voltage of the grid-side port is greater than the first threshold, send a disturbance instruction to the inverter, for the inverter to adjust an output voltage based on the disturbance instruction, and if the voltage of the grid-side port changes with the output voltage of the inverter, report a cable connection fault of the inverter-side port; and
when the voltage of the grid-side port is less than the first threshold, if the voltage of the inverter-side port is greater than the first threshold, the output voltage of the inverter is less than the first threshold, and the inverter is shut down or in a startup process, report a cable connection fault of the grid-side port.

2. The backup power system according to claim 1, wherein the inverter is configured to: control, based on the disturbance instruction, the output voltage to be a first amplitude for first duration and then control the output voltage to be a second amplitude for second duration, wherein the first amplitude is greater than a rated voltage amplitude of the power grid, and the second amplitude is less than the rated voltage amplitude of the power grid; and
the control circuit is configured to: if the voltage of the grid-side port is a third amplitude for third duration, and then the voltage of the grid-side port is a fourth amplitude for fourth duration, report the cable connection fault of the inverter-side port, wherein the third amplitude is greater than the rated voltage amplitude of the power grid and less than the first amplitude, the fourth amplitude is less than the rated voltage amplitude of the power grid and greater than the second amplitude, the third duration is less than the first duration, and the fourth duration is less than the second duration.

3. The backup power system according to claim 1, wherein the inverter is configured to: control, based on the disturbance instruction, the output voltage to be a second amplitude for first duration and then control the output voltage to be a first amplitude for second duration, wherein the first amplitude is greater than a rated voltage amplitude of the power grid, and the second amplitude is less than the rated voltage amplitude of the power grid; and
the control circuit is configured to: if the voltage of the grid-side port is a fourth amplitude for third duration, and then the voltage of the grid-side port is a third amplitude for fourth duration, report the cable connection fault of the inverter-side port, wherein the third amplitude is greater than the rated voltage amplitude of the power grid and less than the first amplitude, the fourth amplitude is less than the rated voltage amplitude of the power grid and greater than the second amplitude, the third duration is less than the first duration, and the fourth duration is less than the second duration.

4. The backup power system according to claim 2 or 3, wherein the first amplitude is (1+k2)Un, the second amplitude is (1-k3)Un, the third amplitude is (1+k4)Un, and the fourth amplitude is (1-k5)Un, wherein
Un is the rated voltage amplitude of the power grid, values of k2, k3, k4, and k5 are between 0 and 1, k5 is less than k3, and k4 is less than k2.

5. The backup power system according to any one of claims 2 to 4, wherein the third duration is less than the first duration, and the fourth duration is less than the second duration.

6. The backup power system according to any one of claims 1 to 5, wherein the control circuit is further configured to: after reporting the cable connection fault, control the on/off-grid controller to be shut down, and send a shutdown instruction to the inverter.

7. The backup power system according to any one of claims 1 to 6, further comprising a system controller, wherein
the system controller is configured to: forward, to the inverter, the disturbance instruction sent by the control circuit, and forward, to the control circuit, the output voltage and an operating status that are sent by the inverter, wherein the operating status comprises on-grid operation, off-grid operation, shutdown, and startup.

8. The backup power system according to any one of claims 1 to 6, wherein the on/off-grid controller further comprises a first power supply port and a second power supply port, the first power supply port is configured to connect to a first load, and the second power supply port is configured to connect to a second load; and
the first power supply port is connected to the inverter-side port, and the second power supply port is connected to the grid-side port.

9. The backup power system according to any one of claims 1 to 7, wherein the switch circuit comprises a first relay and a second relay that are connected in series, the first relay is connected to the inverter-side port, and the second relay is connected to the grid-side port.

10. A power cable connection detection method for a backup power system, comprising:
disconnecting a switch circuit that is in an on/off-grid controller and that is connected between a grid-side port and an inverter-side port, wherein the inverter-side port is configured to connect to an alternating current side of an inverter, and the grid-side port is configured to connect to the power grid;
when a voltage of the inverter-side port is greater than a first threshold and a voltage of the grid-side port is greater than the first threshold, sending a disturbance instruction to the inverter, for the inverter to adjust an output voltage based on the disturbance instruction, and if the voltage of the grid-side port changes with the output voltage of the inverter, reporting a cable connection fault of the inverter-side port; and
when the voltage of the grid-side port is less than the first threshold, if the voltage of the inverter-side port is greater than the first threshold, the output voltage of the inverter is less than the first threshold, and the inverter is shut down or in a startup process, reporting a cable connection fault of the grid-side port.

11. The power cable connection detection method according to claim 10, wherein adjusting, by the inverter, the output voltage based on the disturbance instruction comprises:
controlling, based on the disturbance instruction, the output voltage to be a first amplitude for first duration and then controlling the output voltage to be a second amplitude for second duration, wherein the first amplitude is greater than a rated voltage amplitude of the power grid, and the second amplitude is less than the rated voltage amplitude of the power grid; and
a case in which the voltage of the grid-side port changes with the output voltage of the inverter comprises:
if the voltage of the grid-side port is a third amplitude for third duration, and then the voltage of the grid-side port is a fourth amplitude for fourth duration, reporting the cable connection fault of the inverter-side port, wherein the third amplitude is greater than the rated voltage amplitude of the power grid and less than the first amplitude, the fourth amplitude is less than the rated voltage amplitude of the power grid and greater than the second amplitude, the third duration is less than the first duration, and the fourth duration is less than the second duration.

12. The power cable connection detection method according to claim 10, wherein adjusting, by the inverter, the output voltage based on the disturbance instruction comprises: controlling, based on the disturbance instruction, the output voltage to be a second amplitude for first duration, and controlling the output voltage to be a first amplitude for second duration, wherein the first amplitude is greater than a rated voltage amplitude of the power grid, and the second amplitude is less than the rated voltage amplitude of the power grid; and
a case in which the voltage of the grid-side port changes with the output voltage of the inverter comprises: if the voltage of the grid-side port is a fourth amplitude for third duration, and the voltage of the grid-side port is a third amplitude for fourth duration, reporting the cable connection fault of the inverter-side port, wherein the third amplitude is greater than the rated voltage amplitude of the power grid and less than the first amplitude, the fourth amplitude is less than the rated voltage amplitude of the power grid and greater than the second amplitude, the third duration is less than the first duration, and the fourth duration is less than the second duration.

13. The power cable connection detection method according to claim 11 or 12, wherein the first amplitude is (1+k2)Un, the second amplitude is (1-k3)Un, the third amplitude is (1+k4)Un, and the fourth amplitude is (1-k5)Un, wherein
Un is the rated voltage amplitude of the power grid, values of k2, k3, k4, and k5 are between 0 and 1, k5 is less than k3, and k4 is less than k2.

14. The power cable connection detection method according to any one of claims 11 to 13, wherein the third duration is less than the first duration, and the fourth duration is less than the second duration.

15. The power cable connection detection method according to any one of claims 10 to 14, further comprising: after reporting the cable connection fault, controlling the on/off-grid controller and the inverter to be shut down.
